Europäisches Patentamt

(19) European Patent Office

Office européen des brevets

(11) Publication number: **0 294 167 B1**

(12) **EUROPEAN PATENT SPECIFICATION**

(45) Date of publication of patent specification:
25.09.91 Bulletin 91/39

(51) Int. Cl.⁵: **H01J 3/02, G02B 6/42**

(21) Application number: 88304982.7

(22) Date of filing: 01.06.88

(54) **Optical devices.**

(30) Priority: 01.06.87 GB 8712808

(43) Date of publication of application:
07.12.88 Bulletin 88/49

(45) Publication of the grant of the patent:
25.09.91 Bulletin 91/39

(84) Designated Contracting States:
AT BE CH DE ES FR GB GR IT LI LU NL SE

(56) References cited:
EP-A- 0 199 565
FR-A- 2 581 768
PATENT ABSTRACTS OF JAPAN, vol. 6, no.
182 (E-131)[1060], 18th September 1982, page
108 E 131; & JP-A-57 96 582 (TOKYO SHIBAU-
RA DENKI K.K.) 15-06-1982

(73) Proprietor: BT&D TECHNOLOGIES LIMITED
Whitehouse Road
Ipswich Suffolk IP1 5PB (GB)

(72) Inventor: Musk, Robert William Fieldings Main
Road
Ashbocking Ipswich
Suffolk, IP6 9JT (GB)

(74) Representative: Wolff, Eric
BT&D Technologies Ltd Whitehouse Road
Ipswich, Suffolk IP1 5PB (GB)

EP 0 294 167 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to optical transmitters and in particular though not exclusively to optical transmitters for use in optical communications systems employing optical fibres as transmission medium.

Semiconductor lasers used in conventional laser transmitters have an active region which is of the order of 2 μm in cross-section. In an optical transmission system using optical fibres as the transmission medium, the light emerging from the active region at one facet of the laser, the "front" facet, needs to be coupled into the core of an optical fibre. If the fibre is a single mode fibre, the core is only about 5 μm to 10 μm in diameter.

For many present applications stabilising the output power of a light source is sufficient even though the level at which the power output is stabilised differs arbitrarily from device to device. Simple bi-directional optical links, and optical disk read heads are examples of such applications. Alignment between the laser and a photo-detector monitoring the output of the light source is much less critical for these purposes as a slow speed photo detector has a typical diameter of 250 μm.

An optical read/write head for optical recording and reproduction is described in published European Patent Application EP-A-0199565 (SONY Corp.). The optical read/write head comprises a laser diode transmitter, a photo-diode receiver, and a semi-silvered prism providing a semi-reflecting mirror. Light from the laser transmitter is partially reflected by the semi-reflecting mirror onto the optical recording medium. The modulated beam reflected by the medium is partially transmitted by the same semi-reflecting mirror to the photo-diode of the receiver. The light output of the laser is monitored either by sensing directly the light emerging from the back facet of the laser, or by monitoring a portion of the light output of the front facet of the laser, which is transmitted through the semi-reflecting mirror formed on the prism, and reflected again by a fully reflecting portion of that prism onto a monitoring photo-diode.

A similar arrangement using semi-reflecting mirrors is described in published French patent application FR-A-2581768 (Thomson-CSF), in connection with a bi-directional optical communications link.

In each case the absolute output power of the laser is, within fairly broad limits of specified laser performance, of secondary importance, and may vary from device to device over a considerable range without adverse effects.

However, mainly in newer applications such as optical networks using a plurality of transmitters and/or receivers, for example, the power output of individual transmitters needs to fall within much tighter tolerance limits. Some of the problems encountered in trying to achieve better control over the absolute level of output power of an optical transmitter arise from tolerances in semiconductor device manufacture, of both the laser and the monitoring detector.

Various other difficulties related to the manufacture and assembly of laser transmitters, such as ensuring adequate heat dissipation from the active area of the laser and providing convenient bonding areas for electrical connections to the laser and to the photo-detector, for example, will be well known to the person skilled in the art.

Where only small numbers of transmitters are required, it is obviously possible to select a few suitably matched transmitters from amongst the total manufacturing output in order to fulfil special performance requirements. For large-scale supply of such transmitters this is clearly not a practical approach. The present invention aims to provide an optical transmitter assembly which enables the photo-detector electrical output to be more reliably pre-calibrated with respect to the optical output of the laser, and which thereby avoids or at least mitigates some of the aforementioned problems.

The optical power coupled into the fibre depends on the alignment and distance between the light source and the fibre. On occasion the coupling between source and fibre may be deliberately kept below optimum in order to limit the maximum optical power transmitted through the fibre. The present invention further aims to provide a transmitter assembly in which the electrical output of the photo-detector can be calibrated to the optical power coupled into the fibre rather than the optical output power of the light source.

According to the present invention an optical transmitter assembly comprises an optical source and an optical detector arranged to receive light output from the source indirectly via light deflection means, wherein the light deflection means include a deformable reflector member.

The light source will usually be a semiconductor device, typically a semiconductor laser although in certain applications non-lasing devices such as light emitting diodes (LEDs), and in particular edge-emitting LEDs (ELEDs) may be used instead.

The source, the detector and the reflector member are mounted conveniently on a common support structure.

The support structure may conveniently be a generally planar substrate, preferably of electrically insulating, thermally conductive material.

The aforementioned components may be affixed directly to the support structure or to subsidiary support structures which are, in turn, affixed to or formed on the support structure common to them.

The laser or other light source is conveniently mounted with its light generating region, in the case of lasers or LEDs their active region, away from its mounting surface on the support structure or substrate, in contrast to many earlier arrangements in which a laser had to be mounted with its active region nearest the mounting surface.

The photo-detector is conveniently mounted on a mounting surface of the support structure such that the face of the detector which affords entry of incident light to its active area is in a plane substantially parallel with that mounting surface.

The reflector member preferably comprises a strip of material mounted on the support structure and set at an angle to both the back facet of the laser and the entry face of the photo-detector such that light emerging from the back facet of the laser is reflected onto the entry face of the photo-detector.

The reflector member may consist, for example, of an angled strip of non-tarnishing highly reflective material. Instead, the reflector member may be provided with a suitable non-tarnishing reflector surface, e.g. by gold plating. The strip itself is mounted at one end on the common substrate, and a portion of the strip carrying the reflector extends upwardly, at an angle, to the common substrate.

The beam deflection means may include focusing or de-focusing means. Thus, for example, the reflector member may be shaped to form a focusing reflector.

Employing a reflector member which is deformable, or which has at least a portion which is deformable, allows the direction and amount of the light reflected onto the photo detector to be adjusted. This adjustment can compensate for mounting tolerances as well as for performance tolerances among lasers and/or detectors. Improved matching of electrical detector output to optical source output or the coupled power can thereby be achieved.

The common substrate conveniently comprises a monolithic block of electrically insulating but thermally conductive material, the thermal conductivity being required for dissipation of the heat generated in the light source. Using an electrically insulating material permits appropriate conductor tracks to be formed on the substrate, by metal deposition for example.

The support structure may further provide surface areas for anchorage points for an associated optical fibre, control circuits, and the like.

To calibrate the electrical output power of the photo-detector to the optical output of the source after assembly, one simply measures the optical output of the source and the electrical output of the photo-detector, and adjusts the orientation of the reflector until the photo-detector output is at the desired level. If the photo-detector output is to be calibrated to the optical power coupled into the fibre, one measures instead the optical power at a certain distance along the fibre.

The invention will now be described further by way of example and with reference to the accompanying drawings of which ;

Figure 1 is a schematic perspective view of an optical transmitter assembly ;

Figure 2 is a side view of the assembly of Figure 1 ;

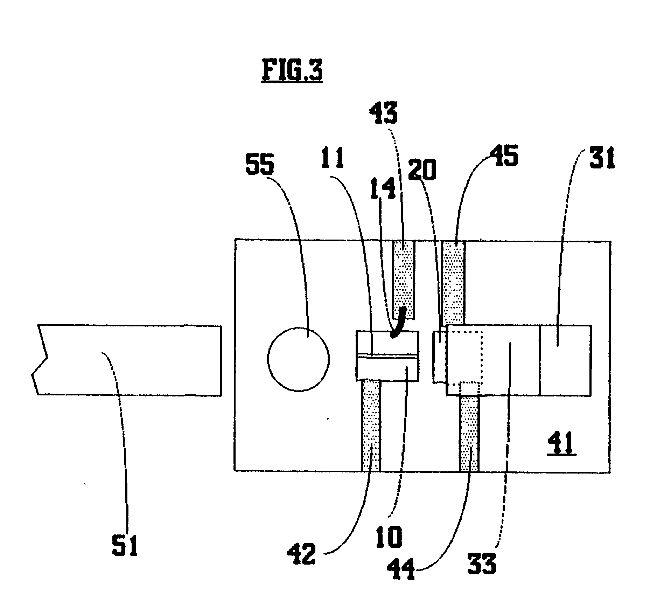

Figure 3 is a top view of the assembly of Figure 1 ;

Figure 4 is a schematic top view of a modified transmitter assembly ; and

Figure 5 is a schematic top view of a further modified transmitter assembly

Referring now also to the drawings, an optical transmitter assembly 1 comprises a laser 10, a photo-detector 20 and a reflector member 30, all mounted on a common planar substrate 40.

The substrate 40 is of a material which is chosen to provide thermal dimensional stability, and good heat conduction and electrical insulation.

The laser 10 may be any one of a variety of suitable semiconductor laser devices whose construction and operation will be readily appreciated by those skilled in the art. The detailed structure of such semiconductor devices will not be discussed here as it is largely immaterial to the performance and understanding of the present invention.

The approximate location of the active region of the laser device is indicated schematically by the narrow stripe 11, and the front and back end-facets by reference numerals 12 and 13 respectively. The laser 10 may be affixed to the substrate 40 by metal solder or in some other suitable manner which allows heat conduction from the laser to the substrate and also provides electrical continuity to the conductor track 42 on top surface 41 of the substrate 40. Another conductor track 43 provides electrical connection to the laser 10 via a bond wire 14.

The optical output of the laser from front facet 12 is coupled via a lens 55 into an optical fibre 51 in the manner described below.

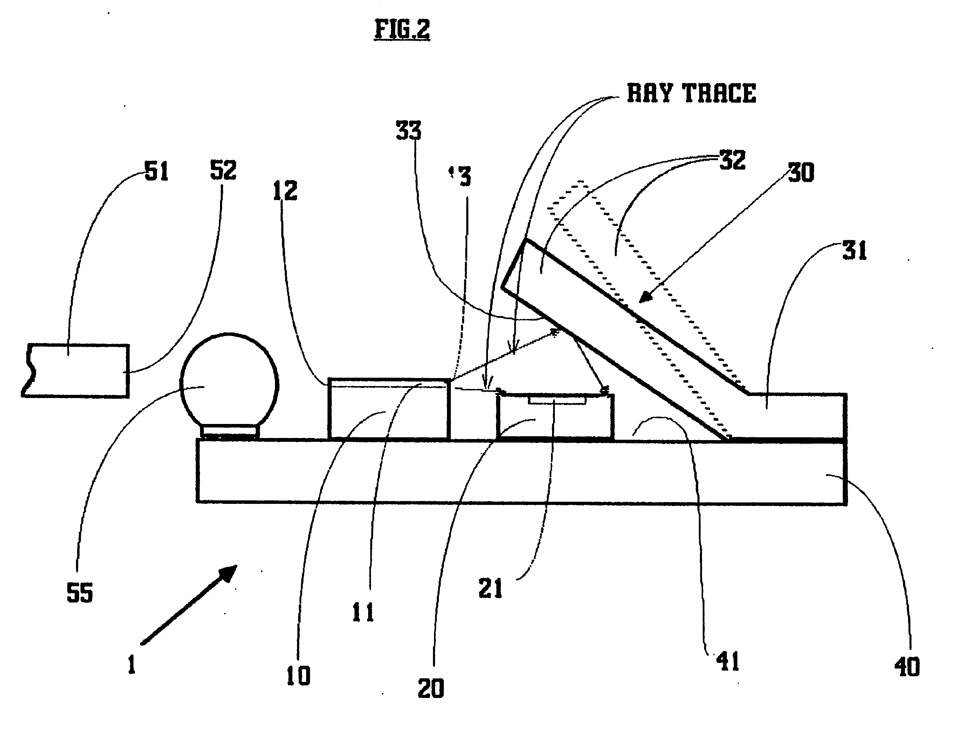

As can be seen from Figure 2 in particular, the laser is mounted so that its active region 11 is remote from, and extends parallel to, the top surface 41 of the substrate 40.

The photo-detector comprises a planar photo diode 20 having its entry face 21 in a plane parallel to the top surface 41 of the substrate 40. Instead of being a device with a planar device structure the photo diode may have a mesa structure, for example. The photo diode 20 is affixed to the substrate 40 in a similar manner to the laser 10, with electrical connection being made via the bottom surface of the body of the photo diode 20 via conductor track 44 and by a bond wire 61 from conductor track 45 to a bonding area 22 on the top-surface of the photo diode 20. The photo diode 20 serves to monitor the total optical output of the laser 10 by sensing the optical output from the back facet 13 of the laser 10. It is well known that the optical output from the back facet 13 is dependent on, but normally much lower than, the optical power output from the front facet 12 of the laser. The light emerging from the back facet 13 of the laser 10 is directed onto the active area 21 of the photo diode 20 via the reflector member 30.

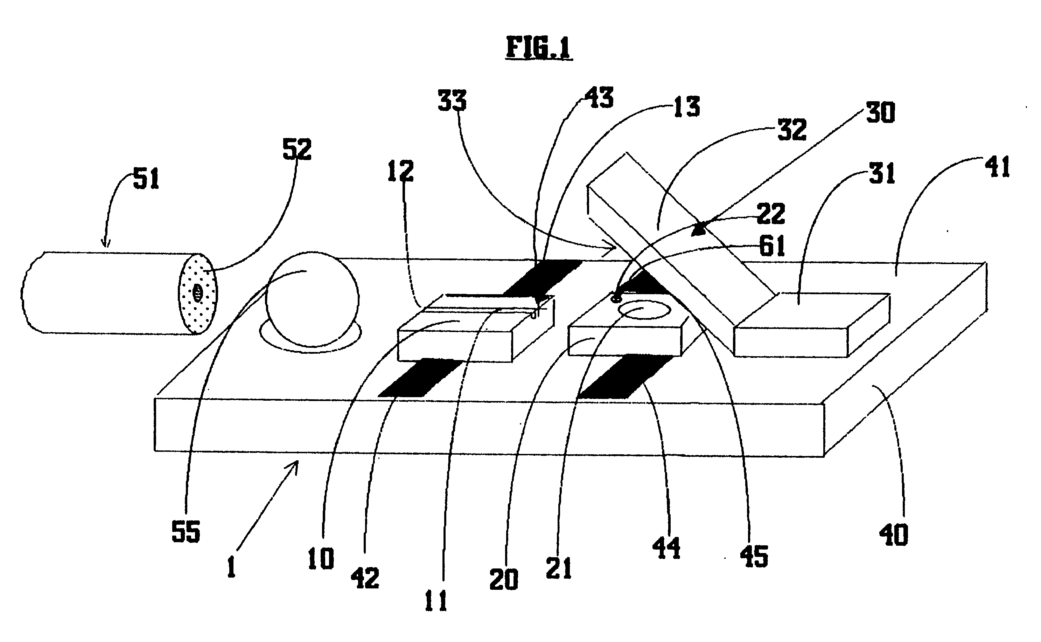

The reflector member 30 consists of a strip of metal or metal alloy in the form of a lazy L. It is affixed by its arm 31 to the top surface 41 of the substrate, again by soldering or in some other suitable manner. The upwardly extending arm 32 provides a reflecting surface area 33 above, and inclined to all of the substrate and the axis of the active region of the laser 10 and the entry face 21 of the photo diode 20. Using a strip which is initially formed in proper L shape, i.e. with its arms extending at a right angle to each other, has been found most convenient for practical assembling. The initially vertically extending arm 32 allows easy access to the photo-detector 20 for bonding purposes. Thereafter, the arm 32 can be bent forward into the configuration shown in Figs. 1 and 2.

Referring now more particularly to Figure 2, it will be seen that light emerging from the back facet 13 of the laser is incident on the reflecting surface 33 and hence is reflected onto the entry face 21 of the photo diode 20.

The optical output from the back facet 13 of the laser 10 is incident, via the reflector 30, on the entry face 21 of the photo diode 20, where it is converted into a corresponding electrical output voltage appearing across tracks 43 and 44. Adjusting the inclination of the upwardly extending arm 32 of the strip 30 in turn changes the direction into which the light is reflected. In this manner, the amount of light incident on the detector, and hence the electrical detector output can be adjusted after completing assembly of the components 10, 20 and 30 on the substrate 40, to compensate for assembly tolerances and device tolerances of both the laser 10 and the photo diode 20. By this adjustment an electrical output signal of the photo-detector 20 can be provided which is in a pre-determined relationship to the optical output signal of the laser 10. The material requirements for the strip are, firstly, that it must be sufficiently malleable to allow the necessary deformation during adjustment and, secondly, it must be sufficiently rigid to tolerate mechanical shocks thereafter without suffering deformation. A strip of annealed Ni of sufficient cross-sectional area would be suitable, for example. Dimensions of 0.2-1 mm width, and .1-.25 mm thickness have been found suitable for a strip in which the arm 31 is 1-2 mm long, and the arm 32 1-3 mm.

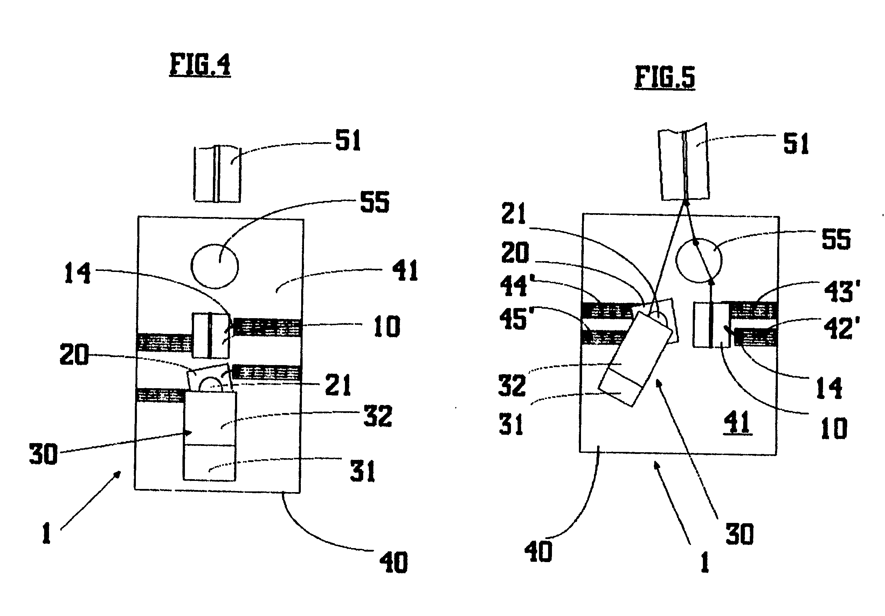

In the assembly just described, the orientation of the side faces of the photo diode 20 is of little significance. Consequently, spurious reflection from these side faces back into the laser cavity can be largely eliminated by mounting the photo diode with its side faces mounted at an angle to the laser 10 as shown in Figure 4. Also, the intensity of any spurious back reflection onto the back facet 12 of the laser and from the anti-reflection coated entry face 21 of the photo diode 20 via the reflector area 33 will normally be fairly insignificant.

An additional advantage of the transmitter assembly described herein stems from the possibility it provides of mounting of the laser diode 10 with its active region uppermost. This leads to several significant advantages. Firstly, it avoids spurious interference effects which can arise from the virtual diffraction slit formed between the active area and the surface 41 when the active region is immediately adjacent the surface 41. Secondly, mounting the laser with its active region lowermost requires exceedingly accurate alignment between the front facet of the laser and the corresponding edge of the substrate : if the substrate projects beyond the laser, interference effects (arising in the manner described above with respect to the back facet) will occur at the front facet; if the laser overhangs the substrate then heat conduction away from the active area is adversely affected leading to reduced device lifetime, or reliability, or both.

Moreover, if the laser is affixed by soldering to the substrate with its active region nearest the substrate, the formation of even a small solder bump may obstruct the light output of the laser and, again, cause interference effects. Using the approach of the present invention allows the laser 10 to be mounted with its active area uppermost, which not only largely avoids these problems, but also enables a considerable simplification in the very critical alignment between laser and output fibre. Moreover, as shown in the drawings, the greatly increased spacing of the active region 11 from the surface 41 of the substrate 40 enables a lens 55 to be interposed between the laser and the fibre 51 to be mounted on the substrate. The lens 55 shown is a spherical lens which is secured to the substrate 40 by means of metal or glass solder, for example. The spacing of the lens from the front facet 11 of the laser is typically a few μm, depending upon the type of lens chosen (e.g. whether the lens is a spherical lens, or a graded index lens, etc).

An other modification of an optical transmitter assembly according to the present invention is shown in Figure 5. Using a spherical lens, spurious reflection back into the laser 10 from the cleaved fibre end-face 52 can be minimised by providing a lateral and/or angular offset between the fibre 51 and the laser 10, as shown in Figure 5. Moreover, reflection on the cleaved end-face 52 of the fibre may be used in place of the strip 30 to reflect a proportion of the lens output power out the photo diode 20. The advantage of this arrangement as shown in Figure 5 is firstly that the laser can be designed for nominally 100% reflection at its back facet 13, resulting in improved laser power output and, secondly, the otherwise undesirable but inevitable reflection of light (approx. 4% for an air-glass interface) at the cleaved fibre end to 51 is advantageously put to use to provide the monitoring signal.

## Claims

1. An optical transmitter assembly comprising an optical source (10) and an optical detector (20) arranged to receive light output from the source (10) indirectly via light deflection means (33, 52), wherein the source (10), the detector (20) and the reflector member (30) are mounted on the same support structure (40), characterised in that the light deflection means (30-33, 52) include a deformable reflector member (30).

2. An assembly as claimed in claim 1, wherein the reflector member (30) comprises a strip (31, 32) of deformable material.

3. An assembly as claimed in claim 1 or 2, wherein the support structure (40) comprises a generally planar substrate.

4. An assembly as claimed in any one of claims 1 to 3, wherein the support structure (40) is of electrically insulating material.

5. An assembly as claimed in any preceding claim, wherein each or all of the source (10), the detector (20) and the reflector member (30) are affixed directly to the support structure (40).

6. An assembly as claimed in any one of claim 1 to 3 wherein at least one of the source (10), the detector (20) or the reflector member (30) is mounted on a subsidiary support which is affixed to said support structure (40).

7. An assembly as claimed in any preceding claim wherein the optical source (10) is a semiconductor device.

8. An assembly as claimed in any one of claims 1 to 7, wherein the optical source (10) is a semiconductor laser device.

9. An assembly as claimed in claim 7 or 8, wherein the optical source (10) is mounted with its active region (11) away from the support structure (40).

10. An assembly as claimed in any preceding claim wherein the photo-detector is mounted on a mounting surface (41) of the support structure (40) such that a face (21) of the photo-detector affording entry of incident light to its active area is substantially parallel with the mounting surface (41) of the support structure (40).

## Patentansprüche

1. Optische Senderanordnung, umfassend eine optische Quelle (10) und einen optischen Detektor (20), der so angeordnet ist, daß er Ausgangslicht von der Quelle (10) indirekt über Lichtablenkeinrichtungen (33, 52) empfängt, wobei die Quelle (10), der Detektor (20) und der Reflektor (30) auf der gleichen Tragkonstruktion (40) angeordnet sind, dadurch gekennzeichnet, daß die Lichtablenkeinrichtungen (30-33, 52) einen verformbaren Reflektor (30) aufweisen.

2. Anordnung nach Anspruch 1, wobei der Reflektor (30) einen Streifen (31, 32) aus verformbarem Material umfaßt.

3. Anordnung nach Anspruch 1 oder 2, wobei die Tragkonstruktion (40) ein allgemein planares Substrat umfaßt.

4. Anordnung nach einem der Ansprüche 1-3, wobei die Tragkonstruktion (40) aus elektrisch isolierendem Material besteht.

5. Anordnung nach einem der vorhergehenden Ansprüche, wobei die Quelle (10), der Detektor (20) und der Reflektor (30) jeweils für sich oder sämtlich direkt auf der Tragkonstruktion (40) befestigt sind.

6. Anordnung nach einem der Ansprüche 1-3, wobei wenigstens die Quelle (10) oder der Detektor (20) oder der Reflektor (30) auf einem auf der Tragkonstruktion (40) befestigten Hilfsträger angeordnet ist.

7. Anordnung nach einem der vorhergehenden Ansprüche, wobei die optische Quelle (10) ein Halbleiterbauelement ist.

8. Anordnung nach einem der Ansprüche 1-7, wobei die optische Quelle (10) ein Halbleiterlaser-Bauelement ist.

9. Anordnung nach Anspruch 7 oder 8, wobei die optische Quelle (10) so angeordnet ist, daß ihr aktiver Bereich (11) der Tragkonstruktion (40) abgewandt ist.

10. Anordnung nach einem der vorhergehenden Ansprüche, wobei der Fotodetektor auf einer Befestigungsfläche (41) der Tragkonstruktion (40) so angeordnet ist, daß eine Fläche (21) des Fotodetektors, die den Eintritt von auffallendem Licht zu dem aktiven Bereich ermöglicht, zu der Befestigungsfläche (41) der Tragkonstruktion (40) im wesentlichen parallel ist.

## Revendications

1. Une structure d'émetteur optique comprenant une source optique (10) et un détecteur optique (20) disposé de façon à recevoir l'émission lumineuse de la source (10) de façon indirecte, par l'intermédiaire de moyens de déflexion de lumière (33, 52), dans laquelle la source (10), le détecteur (20) et l'élément réflecteur (30) sont montés sur la même structure de support (40), caractérisée en ce que les moyens de déflexion de lumière (30-33, 52) comprennent un élément réflecteur déformable (30).

2. Une structure selon la revendication 1, dans laquelle l'élément réflecteur (30) consiste en une bande (31, 32) d'un matériau déformable.

3. Une structure selon la revendication 1 ou 2, dans laquelle la structure de support (40) consiste en un substrat de forme générale plane.

4. Une structure selon l'une quelconque des revendications 1 à 3, dans laquelle la structure de support (40) consiste en un matériau électriquement isolant.

5. Une structure selon l'une quelconque des revendications précédentes, dans laquelle la source (10), le détecteur (20) et l'élément réflecteur (30) sont tous fixés directement sur la structure de support (40).

6. Une structure selon l'une quelconque des revendications 1 à 3, dans laquelle l'un au moins des éléments comprenant la source (10), le détecteur (20) ou l'élément réflecteur (30) est monté sur un support auxiliaire qui est fixé sur la structure de support (40).

7. Une structure selon l'une quelconque des revendications précédentes, dans laquelle la source optique (10) est un dispositif à semiconducteurs.

8. Une structure selon l'une quelconque des revendications 1 à 7, dans laquelle la source optique (10) est un dispositif laser à semiconducteurs.

9. Une structure selon la revendication 7 ou 8, dans laquelle la source optique (10) est montée avec sa région active (11) du côté opposé à la structure de support (40).

10. Une structure selon l'une quelconque des revendications précédentes, dans laquelle le photodétecteur est monté sur une surface de montage (41) de la structure de support (40), d'une manière telle qu'une face (21) du photodétecteur par laquelle la lumière incidente entre dans la région active du photodétecteur, soit pratiquement parallèle à la surface de montage (41) de la structure de support (40).

# FIG.1

EP 0 294 167 B1

EP 0 294 167 B1

FIG.2

RAY TRACE

31
30
32
33
'3
12
52
51
55
1
10
11
20
21
41
40

8

FIG.3

EP 0 294 167 B1

## FIG.4

## FIG.5